# EUROPEAN PATENT APPLICATION

(11) **EP 4 579 730 A1**
(43) Date of publication of application: **02.07.2025**
(21) Application number: 24210806.6
(22) Date of filing: 05.11.2024
(51) Int. Cl.: H01L 23/31, H01L 21/56, H01L 23/367, H01L 23/538, H01L 23/433

(54) **PRE-FABRICATED COMPONENT-HYBRIDS FOR EMBEDDING IN A CORE**

(30) Priority: 26.12.2023 US 202318396371
(71) Applicant: INTEL Corporation, Santa Clara, CA 95054 (US)
(72) Inventor: Raman, Srinivasan, Chandler, 85286 (US); Pietambaram, Srinivas Venkata Ramanuja, Chandler, 85249 (US)
(74) Representative: Goddar, Heinz J.

(57) **Abstract**

Embodiments disclosed herein include assemblies with component substrates that are coupled to spacer base substrates. In an embodiment, such an apparatus comprises a first substrate with a first width, and a first layer on the first substrate. In an embodiment, a second substrate with a second width is over the first layer, and the second width is smaller than the first width. In an embodiment, a second layer is over the first substrate and around the second substrate.

## Description

### BACKGROUND

As advanced packaging is enabling more aggressive computation capability, high power and high quality power delivery is needed to support all of the overlying chiplets. The ability to embed passive components (e.g., capacitors, inductors, resistors, etc.) into the package substrate will enable improved performance compared to placing the passive components on the land side of the package. Embedding components in the core is beneficial because there is less routing in the core compared to overlying and underlying buildup layers. As such, space within the package substrate is more fully utilized.

However, substrate core thickness is defined by the total package thermomechanical stress level. This required thickness can be significantly different than the thickness of the passive component. For example, in the case of a deep trench capacitor (DTC), the DTC is fabricated on a silicon wafer. The wafer will have a thickness that is potentially hundreds of microns different than the thickness of the core, which can be approximately 1.0mm or greater. Placing such passive components in deep cavities through the core can be problematic. For example, the passive components may shift or rotate during embedding.

### BRIEF DESCRIPTION OF THE DRAWINGS

Figure 1 is a cross-sectional illustration of a core with an embedded passive component that has shifted during the embedding process, in accordance with an embodiment.
Figure 2A is a cross-sectional illustration of an assembly with a substrate, a component on the substrate, and a layer around the substrate, in accordance with an embodiment.
Figure 2B is a cross-sectional illustration of an assembly with a substrate, a component, and a layer around the substrate, in accordance with an embodiment.
Figure 2C is a cross-sectional illustration of an assembly with a substrate with a pair of components on the substrate and surrounded by a layer, in accordance with an embodiment.
Figures 3A - 3F are cross-sectional illustrations depicting a process for forming with components on a substrate, in accordance with an embodiment.
Figure 3G is a process flow diagram of a process for forming assemblies with a reconstitution process, in accordance with an embodiment.
Figures 4A - 4F are cross-sectional illustrations depicting a process for embedding an assembly in a cavity through a core, in accordance with an embodiment.
Figure 5A is a cross-sectional illustration of a portion of a package substrate with a pair of assemblies embedded in a cavity through a core, in accordance with an embodiment.
Figure 5B is a cross-sectional illustration of a portion of a package substrate with a pair of assemblies with different form factors embedded in a cavity through a core, in accordance with an embodiment.
Figure 6A is a cross-sectional illustration of a portion of a package substrate with a first assembly in a first cavity and a second assembly in a second cavity, in accordance with an embodiment.
Figure 6B is a cross-sectional illustration of a portion of a package substrate with a first assembly in a first cavity and a second assembly in a second cavity, where the first assembly is different than the second assembly, in accordance with an embodiment.
Figure 7 is a cross-sectional illustration of an electronic system with a package substrate that includes an assembly embedded in a core of the package substrate, in accordance with an embodiment.
Figure 8 is a schematic of a computing device built in accordance with an embodiment.

### EMBODIMENTS OF THE PRESENT DISCLOSURE

Described herein are electronic systems, and more particularly, assemblies that include a base substrate and a component substrate that are placed in cavities through a core of package substrates, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

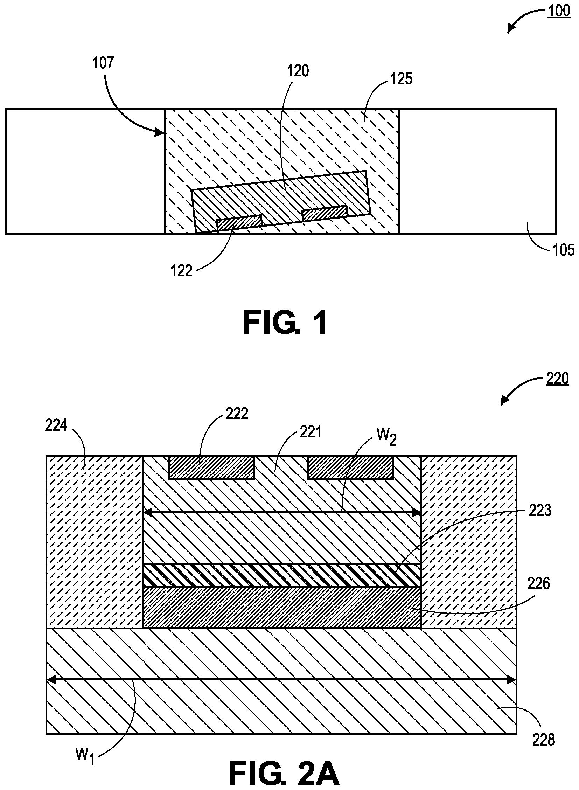

As noted above, introducing passive components (e.g., inductors, capacitors, resistors, etc.) into the package substrate is desirable to improve power delivery and performance for the overlying chiplets compared to placing the passive components on the land side of the package substrate. This is due, at least in part, to the passive components being physically closer to the chiplets when they are integrated into the package substrate. One suitable location in the package substrate for the passive components is the core. The core has underutilized space that can be leveraged to house the passive components. However, the thickness of the passive components is usually smaller than a thickness of the core. This can lead to integration and manufacturing issues. Examples of these drawbacks can be seen in Figure 1.

Referring now to Figure 1, a cross-sectional illustration of a portion of a package substrate 100 is shown, in accordance with an embodiment. The package substrate 100 may comprise a core 105. The core 105 may sometimes be referred to simply as a substrate. The core 105 may be a glass core, an organic core, or the like. In an embodiment, a cavity 107 passes at least partially through the core 105. For example, in Figure 1 the cavity 107 passes entirely through the core 105.

In an embodiment, a component 120 is provided in the cavity 107. The component 120 may have a thickness that is smaller than a thickness of the core 105. For example, the component 120 may have a thickness that is hundreds of microns thinner than the core 105. The component 120 is secured within the cavity 107 through the use of a fill layer 125. The fill layer 125 may be a dielectric material, such as a mold layer, an epoxy, an adhesive, or the like. However, during the filling process, the component 120 may shift and/or rotate. The movement of the component 120 may be due, at least in part, to the introduction of pressure to the component 120 during the filling process. As shown, the component 120 has tilted so that one side is raised up from the bottom of the core 105. This may make it difficult to make electrical contact to the pads 122 that are at the bottom of the component 120 in subsequent processing operations.

Accordingly, embodiments disclosed herein reduce movement of the electrically passive component by integrating the component 120 into a larger assembly. The assembly includes a substrate for supporting the component 120. The thickness of the substrate can be modified in order to increase the thickness of the assembly. For example, the assembly may have a thickness that is substantially equal to a thickness of the core in which the assembly will be embedded. In some embodiments, the component 120 is coupled to the substrate by an adhesive layer. In order to improve the adhesion, a copper layer may also be provided between the adhesive layer and the substrate. A mold layer may surround the component 120.

The assemblies described herein can be fabricated through the use of a reconstitution process. For example, a large substrate is provided and a plurality of components 120 are coupled to the substrate. A layer is then molded over and around the components 120. After molding, the individual assemblies can be singulated from the reconstituted substrate using sawing, laser ablation, etching, or the like.

Referring now to Figure 2A, a cross-sectional illustration of an assembly 220 is shown, in accordance with an embodiment. In an embodiment, the assembly 220 may comprise an electrically passive component. That is, the assembly 220 may include one or more of an inductor, a capacitor, a resistor, or the like. In a particular embodiment, the passive component may be a deep trench capacitor (DTC). For example, the electrically passive component may be integrated into and/or part of a component substrate 221. Routing layer (not shown) may also be provided over the component substrate 221 in some embodiments. In an embodiment, the component substrate 221 may comprise a semiconductor material, such as silicon. Though, other material classes may be used for the component substrate 221, such as ceramics, glass, or the like.

In the Figures described herein, the component substrate 221 is shown as a simple layer. The electrical routing (e.g., traces, pads, plates, electrodes), insulators, dielectrics (e.g., high-k dielectrics for capacitors), magnetic material (e.g., for inductors), and/or the like are omitted for simplicity. However, it is to be appreciated that assembly 220 may include any structures that enable functionality of various passive components. Though, pads 222 are illustrated on the component substrate 221. The pads 222 may comprise copper or other suitable electrically conductive material. In the illustrated embodiment, the pads 222 are recessed into the top surface of the component substrate 221. Other embodiments may include pads 222 that extend up from the top surface of the component substrate 221.

In an embodiment, the component substrate 221 is coupled to a base substrate 228. The base substrate 228 may be a different material that the component substrate 221. In some instances, the base substrate 228 may comprise organic dielectric material with (or without) fiber reinforcement. For example, the base substrate 228 may have a material that is similar to the material of organic core layers used in electronics packaging substrates. In other instances, the base substrate 228 may comprise a resin or resin based material, a ceramic material, a glass material, a metallic material, or the like.

In some embodiments, the base substrate 228 may have a first width W₁, and the component substrate 221 may have a second width W₂. In an embodiment, the second width W₂ is narrower than the first width W₁. A layer 224 may be provided over an area of the base substrate 228 that is not covered by the component substrate 221. The layer 224 may be a molding material, such as an epoxy, a resin, or the like. In the illustrated embodiment, the layer 224 covers sidewalls of the component substrate 221. However, in other embodiments (as will be described in greater detail below), the layer 224 may also be provided over a top surface of the component substrate 221.

In an embodiment, the component substrate 221 may be coupled to the base substrate 228 through one or more coupling layers. For example, in Figure 2A an adhesive layer 223 is provided below the component substrate 221. The adhesive layer 223 may be a die bonding film (DBF) or the like. The other surface of the adhesive layer 223 may contact an adhesion promoting layer 226. The adhesion promoting layer 226 may comprise copper or the like. The adhesion promoting layer 226 may have a surface roughness, material composition, or other property that improves adhesion strength between the adhesive layer 223 and the base substrate 228. The adhesion promoting layer 226 may also be used as a fiducial mark during assembly, as will be described in greater detail below.

In the embodiment shown in Figure 2A, widths of the adhesive layer 223 and the adhesion promoting layer 226 are substantially equal to the second width W₂ of the component substrate 221. Though, it is to be appreciated that one or both of the adhesive layer 223 and the adhesion promoting layer 226 may be a different width than the component substrate 221. For example, the adhesive layer 223 and/or the adhesion promoting layer 226 may have widths that are greater than the second width W₂ of the component substrate 221. As used herein, "substantially equal" may refer to two values that are within ten percent of each other. For example, a first width W₁ that is between 900µm and 1,100µm may be substantially equal to a second width W₂ that is 1,000µm.

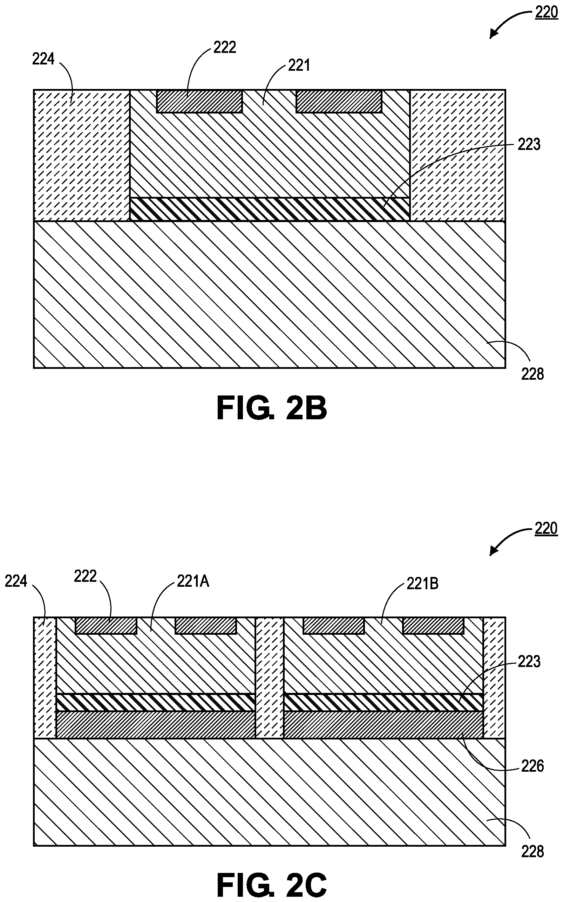

Referring now to Figure 2B, a cross-sectional illustration of an assembly 220 is shown, in accordance with an additional embodiment. The assembly 220 in Figure 2B may be similar to the assembly 220 in Figure 2A, with the exception of the coupling between the component substrate 221 and the base substrate 228. For example, only a single layer is provided between the component substrate 221 and the base substrate 228. The single layer may be an adhesive layer 223, such as a DBF. In some instances, the adhesion strength provided by the adhesive layer 223 is sufficient to hold the component substrate 221 in place during the molding process to form the layer 224. After the layer 224 is formed, the layer 224 also helps secure the component substrate 221.

Referring now to Figure 2C, a cross-sectional illustration of an assembly 220 is shown, in accordance with an additional embodiment. The assembly 220 in Figure 2C is similar to the assembly 220 in Figure 2A, with the addition of a second component substrate 221. For example, a first component substrate 221A and a second component substrate 221B are adjacent to each other over the base substrate 228. Each component substrate 221A and 221B may be coupled to the base substrate 228 by an adhesion stack (e.g., adhesion promoting layer 226 and adhesive layer 223). In the illustrated embodiment, the component substrates 221A and 221B have different adhesion stacks. Though, in other embodiments, a single adhesion stack may have a width large enough to accommodate both component substrates 221A and 221B.

While two component substrates 221A and 221B are shown in Figure 2C, it is to be appreciated that any number of component substrates 221 may be integrated into a single assembly 220. Increasing the number of component substrates 221 may simplify integration processes with the package substrate since fewer transfer processes may be needed (e.g., a pick-and-place process) in order to provide a desired passive component capacity (e.g., a necessary capacitance, inductance, resistance, etc.).

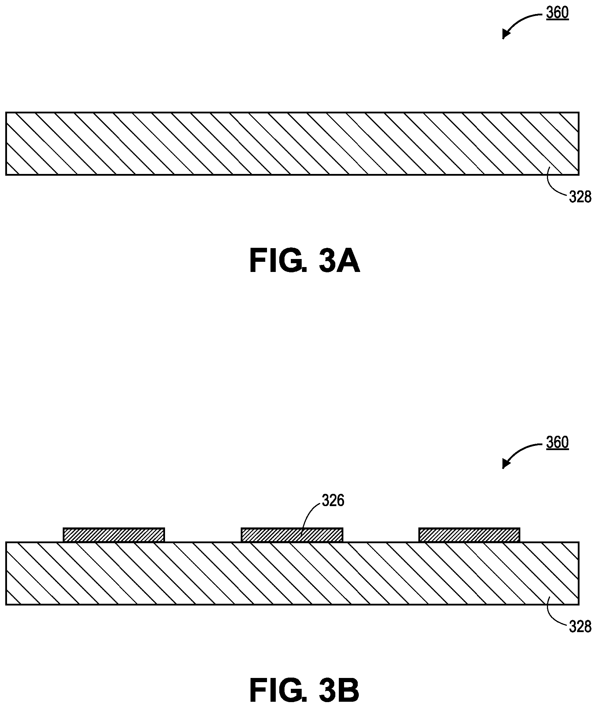

Referring now to Figures 3A - 3F, a series of cross-sectional illustrations depicting a process for forming assemblies 320 is shown, in accordance with an embodiment. The assemblies 320 in Figures 3A - 3F are formed with a reconstitution process. That is, individual component substrate 321 are placed on a larger base substrate 328. A layer 324 is overmolded over the component substrate 321 to form a reconstituted substrate 360. The reconstituted substrate 360 is singulated to form individual assemblies 320.

Referring now to Figure 3A, a cross-sectional illustration of a portion of a reconstituted substrate 360 is shown, in accordance with an embodiment. The reconstituted substrate 360 may comprise a base substrate 328. The base substrate 328 may be an organic core material (e.g., an organic dielectric with (or without) fiber reinforcement), a resin material, a ceramic material, a glass material, a metallic material or the like.

A thickness of the base substrate 328 is chosen in order to provide a desired total thickness for the subsequently formed assemblies 320. Particularly, the component substrates 321 (not shown in Figure 3A) typically come with a fixed thickness. Accordingly, the desired thickness of the assembly 320 is obtained by increasing/decreasing the thickness of the base substrate 328. In an embodiment, the base substrate 328 may have a thickness that is approximately 150µm or larger, approximately 500µm or larger, approximately 750µm or larger, approximately 1,000µm or larger, or approximately 1,500µm or larger. In some instances, base substrates 328 may be commonly available at thicknesses with 100µm increments (with an approximately 10% tolerance) or a 50µm increments (with an approximately 10% tolerance). Though, the thickness of the base substrate 328 may be any suitable thickness, and embodiments are not limited to commercially available standards. The base substrate 328 may have a footprint or area that is suitable for accommodating a plurality of assemblies 320. As used herein, "approximately" may refer to a range of values within ten percent of a stated value. For example, approximately 1,000µm may refer to a range of values between 900µm and 1,000µm.

Referring now to Figure 3B, a cross-sectional illustration of the reconstituted substrate 360 at a different stage of manufacture is shown, in accordance with an embodiment. As shown, a plurality of adhesion promoting layers 326 are formed over the base substrate 328. The adhesion promoting layers 326 may comprise a metallic layer, such as one comprising copper. In an embodiment, a blanket layer of metallic material is disposed across a surface of the base substrate 328. The blanket layer is then patterned (e.g., through etching, or another subtractive process) in order to provide isolated adhesion promoting layers 326 across the base substrate 328. In other embodiments, an additive process is used to form the adhesion promoting layers 326. For example, a semi-additive process (SAP) may be used in order to form the adhesion promoting layers 326. In some embodiments, a surface treatment may be applied to the adhesion promoting layers 326. For example, a surface roughening process may be used to improve adhesion properties of the adhesion promoting layers 326.

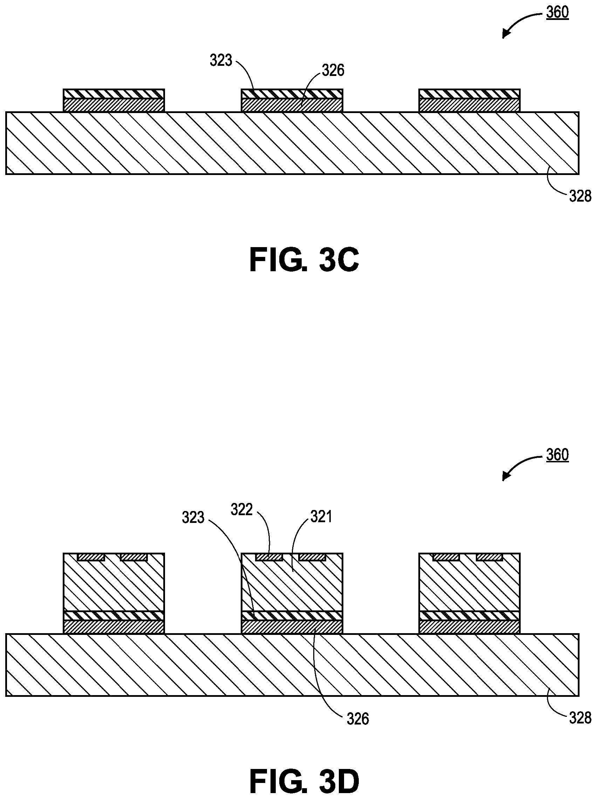

Referring now to Figure 3C, a cross-sectional illustration of the reconstituted substrate 360 at a different stage of manufacture is shown, in accordance with an embodiment. As shown, adhesive layers 323 may be provided over the adhesion promoting layers 326. The adhesive layers 323 may be DBFs in some embodiments. The adhesion promoting layers 326 may be used as fiducial marks in order to accurately place the adhesive layers 323. In the illustrated embodiment, the adhesive layers 323 are over the adhesion promoting layers 326. Though, in other embodiments the adhesive layers 323 may directly contact the base substrate 328 (e.g., similar to the embodiment shown in Figure 2B).

Referring now to Figure 3D, a cross-sectional illustration of the reconstituted substrate 360 after component substrates 321 are added is shown, in accordance with an embodiment. In an embodiment, the component substrates 321 may each be coupled to the base substrate 328 through the adhesive layer 323 and the adhesion promoting layers 326. The component substrates 321 may be similar to any component substrates described in greater detail herein. For example, the component substrates 321 may comprise passive electrical devices, such as inductors, capacitors, resistors, or the like. The component substrates 321 may comprise silicon or any other suitable substrate material for building passive devices. In an embodiment, pads 322 may be provided at a top surface of the component substrates 321. The pads 322 may be on surfaces of the component substrates 321 that faces away from the base substrate 328.

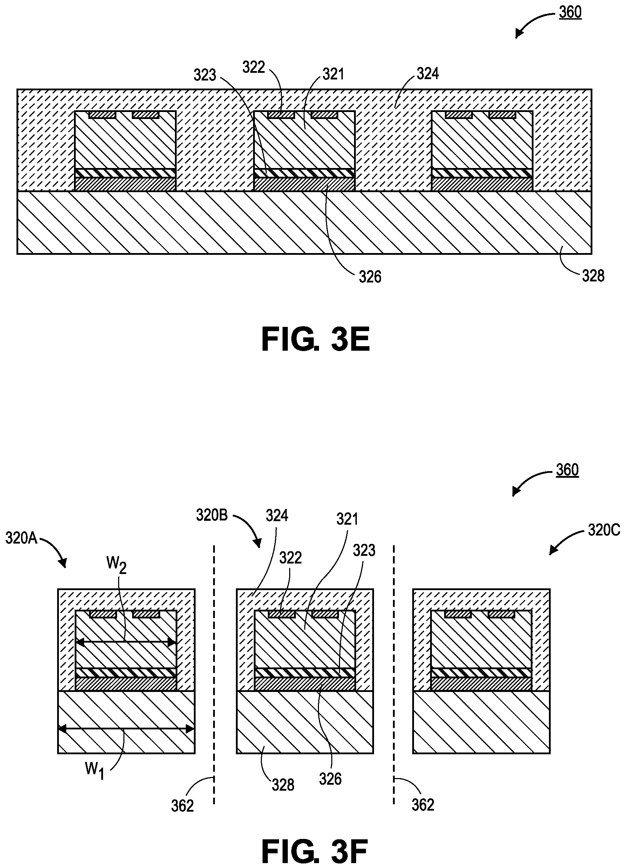

Referring now to Figure 3E, a cross-sectional illustration of the reconstituted substrate 360 after a layer 324 is disposed over the base substrate 328 is shown, in accordance with an embodiment. The layer 324 may be a material suitable for molding, such as an epoxy, a resin based material, or the like. After deposition (e.g., through a molding process), the layer 324 may be partially cured. That is, the layer 324 may still be deformable under reasonable application of pressure. This property can be used in subsequent assembly operations including integration into a core of a package substrate. In an embodiment, the layer 324 may contact the exposed surfaces of the base substrate 328. The layer 324 also covers sidewall surfaces of the component substrate 321. Additionally, the top surface of the component substrate 321 may be covered by the layer 324.

Referring now to Figure 3F, a cross-sectional illustration of the reconstituted substrate 360 after singulation is shown, in accordance with an embodiment. The reconstituted substrate 360 may be singulated along lines 362 between the component substrates 321. The singulation process may result in the formation of a plurality of assemblies 320. For example, three assemblies 320A, 320B, and 320C are shown in Figure 3F. In an embodiment, the singulation process may include a mechanical process (e.g., sawing), a laser ablation process, an etching process, or the like.

In an embodiment, the assemblies 320 may each include a portion of the base substrate 328 with a component substrate 321 provided above the base substrate 328. The base substrate 328 may have a first width Wi, and the component substrate 320 may have a second width W₂ that is narrower than the first width W₁. The layer 324 may have a width that is substantially equal to the first width W₁.

In an embodiment, the completed assemblies 320 may have a thickness (from the bottom of base substrate 328 to the top of the layer 324) that is approximately 500µm or greater, approximately 750µm or greater, approximately 1,000µm or greater, or approximately 1,500µm or greater. As will be described in greater detail below, the total thickness of the assembly 320 may be greater than a thickness of the core in which the assembly 320 will be embedded. This is due to the subsequent compression of the layer 324 during package substrate assembly (as will be described in greater detail below).

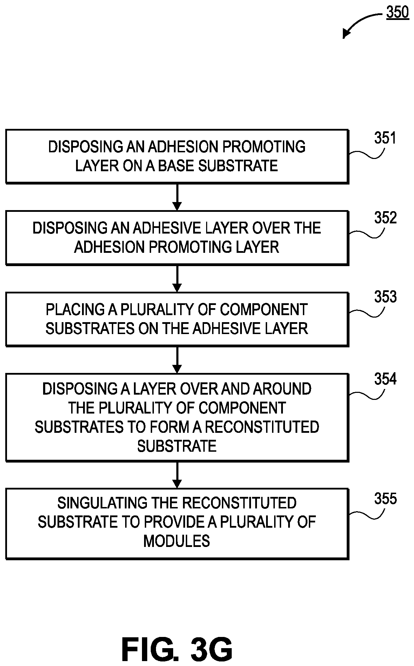

Referring now to Figure 3G, a process flow diagram of a process 350 for forming assemblies with a reconstitution process is shown, in accordance with an embodiment. In an embodiment, the process 350 may begin with operation 351, which comprises disposing an adhesion promoting layer on a base substrate. The operation 351 may include processes and structures similar to those described herein with respect to Figure 3A and/or Figure 3B.

In an embodiment, the process 350 may continue with operation 352, which comprises disposing an adhesive layer over the adhesion promoting layer. The operation 352 may include processes and structures similar to those described herein with respect to Figure 3C.

In an embodiment, the process 350 may continue with operation 353, which comprises placing a plurality of component substrates on the adhesive layer. The operation 353 may include processes and structures similar to those described herein with respect to Figure 3D.

In an embodiment, the process 350 may continue with operation 354, which comprises disposing a layer over and around the plurality of component substrates to form a reconstituted substrate. The operation 354 may include processes and structures similar to those described herein with respect to Figure 3E.

In an embodiment, the process 350 may continue with operation 355, which comprises singulating the reconstituted substrate to provide a plurality of assemblies. The operation 355 may include processes and structures similar to those described herein with respect to Figure 3F.

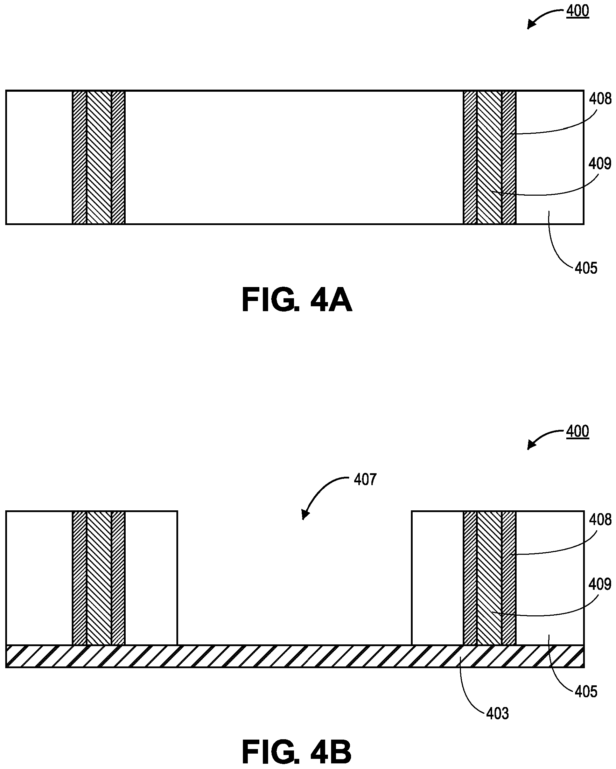

Referring now to Figures 4A - 4F, a series of cross-sectional illustrations depicting a process for embedding an assembly 420 into the core 405 of a package substrate 400 is shown, in accordance with an embodiment. In an embodiment, the assembly 420 may include a component substrate 421 that is thinner than the core 405.

Referring now to Figure 4A, a cross-sectional illustration of a portion of a package substrate 400 is shown, in accordance with an embodiment. In an embodiment, the package substrate 400 may comprise a core 405. The core 405 may be any suitable core material, such as an organic core 405, a glass core 405, or the like. In the case of a glass core 405, the glass core 405 may be substantially all glass. The glass core 405 may be a solid mass comprising a glass material with an amorphous crystal structure where the solid glass core may also include various structures - such as vias, cavities, channels, or other features - that are filled with one or more other materials (e.g., metals, metal alloys, dielectric materials, etc.). As such, glass core 405 may be distinguished from, for example, the "prepreg" or "RF4" core of a Printed Circuit Board (PCB) substrate which typically comprises glass fibers embedded in a resinous organic material, such as an epoxy.

The glass core 405 may have any suitable dimensions. In a particular embodiment, the glass core 405 may have a thickness that is approximately 50µm or greater. For example, the thickness of the glass core 405 may be between approximately 50µm and approximately 1.4mm. Though, smaller or larger thicknesses may also be used. The glass core 405 may have edge dimensions (e.g., length, width, etc.) that are approximately 10mm or greater. For example, edge dimensions may be between approximately 10mm to approximately 250mm. Though, larger or smaller edge dimensions may also be used. More generally, the area dimensions of the glass core 405 (from an overhead plan view) may be between approximately 10mm x 10mm and approximately 250mm x 250mm. In an embodiment, the glass core 405 may have a first side that is perpendicular or orthogonal to a second side. In a more general embodiment, the glass core 405 may comprise a rectangular prism volume with sections (e.g., vias) removed and filled with other materials (e.g., metal, etc.).

The glass core 405 may comprise a single monolithic layer of glass. In other embodiments, the glass core 405 may comprise two or more discrete layers of glass that are stacked over each other. The discrete layers of glass may be provided in direct contact with each other, or the discrete layers of glass may be mechanically coupled to each other by an adhesive or the like. The discrete layers of glass in the glass core 405 may each have a thickness less than approximately 50µm. For example, discrete layers of glass in the glass core 405 may have thicknesses between approximately 25µm and approximately 50µm. Though, discrete layers of glass may have larger or smaller thicknesses in some embodiments. As used herein, "approximately" may refer to a range of values within ten percent of the stated value. For example approximately 50µm may refer to a range between 45µm and 55µm.

The glass core 405 may be any suitable glass formulation that has the necessary mechanical robustness and compatibility with semiconductor packaging manufacturing and assembly processes. For example, the glass core 405 may comprise aluminosilicate glass, borosilicate glass, alumino-borosilicate glass, silica, fused silica, or the like. In some embodiments, the glass core 405 may include one or more additives, such as, but not limited to, Al₂O₃, B₂O₃, MgO, CaO, SrO, BaO, SnO₂, Na₂O, K₂O, SrO, P₂O₃, ZrOz, Li₂O, Ti, or Zn. More generally, the glass core 405 may comprise silicon and oxygen, as well as any one or more of aluminum, boron, magnesium, calcium, barium, tin, sodium, potassium, strontium, phosphorus, zirconium, lithium, titanium, or zinc. In an embodiment, the glass core 405 may comprise at least 23 percent silicon (by weight) and at least 26 percent oxygen (by weight). In some embodiments, the glass core 405 may further comprise at least 5 percent aluminum (by weight).

In an embodiment, the core 405 may comprise vias 408 that pass through at least a portion of the thickness of the core 405. The vias 408 may comprise an electrically conductive material, such as copper or the like. In the illustrated embodiment, the vias 408 are plated through hole (PTH) structures with an insulating plug 409. However, other embodiments may include vias 408 that are fully filled with metallic material. While the sidewalls of the vias 408 are substantially vertical in Figure 4A, the vias 408 may have any shaped profile, including sloped or tapered sidewalls.

Referring now to Figure 4B, a cross-sectional illustration of the portion of the package substrate 400 after a cavity 407 is formed is shown, in accordance with an embodiment. In an embodiment, the cavity 407 may pass at least partially through a thickness of the core 405. For example, in Figure 4B the cavity 407 passes entirely through the core 405. In an embodiment, the sidewalls of the cavity 407 may be substantially vertical. Though, the cavity 407 may also have sloped or non-planar sidewalls. In an embodiment, a tape 403 or other temporary carrier may be provided below the core 405. The tape 403 may span across the bottom of the cavity 407 in order to provide a support surface for supporting the assembly 420 in a subsequent processing operation.

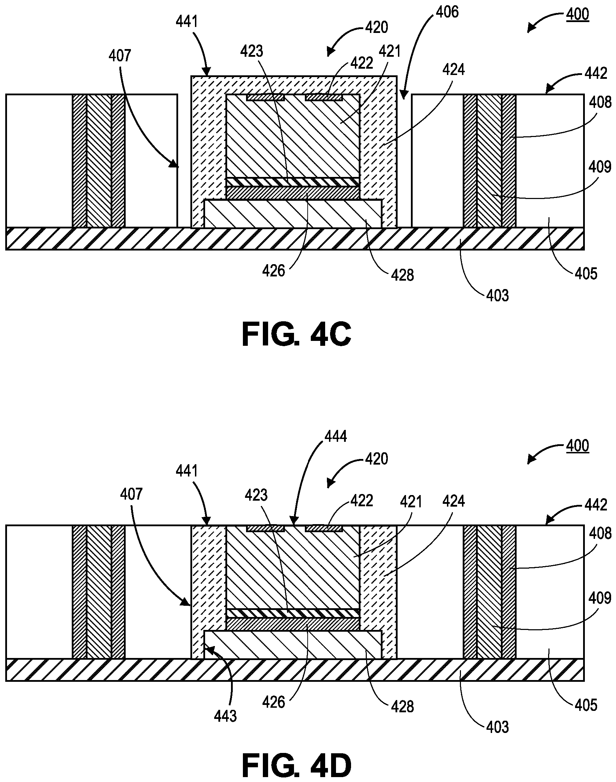

Referring now to Figure 4C, a cross-sectional illustration of the portion of the package substrate 400 after an assembly 420 is inserted into the cavity 407 is shown, in accordance with an embodiment. The assembly 420 may be inserted into the cavity 407 with a pick-and-place process, a manual process, or any other suitable process. In an embodiment, the assembly 420 may be similar to any of the assemblies described in greater detail herein. For example, the assembly 420 may comprise a base substrate 428 that is coupled to a component substrate 421 by an adhesion promoting layer 426 and an adhesion layer 423. A layer 424 may be provided over and around the component substrate 421. The component substrate 421 may comprise a passive electrical component, such as an inductor, a capacitor, or a resistor. In an embodiment pads 422 may be provided on the component substrate 421.

In an embodiment, the assembly 420 may have a width that is narrower than a width of the cavity 407. This may result in the formation of gaps 406 between the sidewall of the cavity 407 and the sidewall of the assembly 420. In an embodiment, the assembly 420 may have a thickness that is greater than a thickness of the core 405. As such, a top surface 441 of the layer 424 may be above a top surface 442 of the core 405.

Referring now to Figure 4D, a cross-sectional illustration of the portion of the package substrate 400 after the assembly 420 is compressed is shown, in accordance with an embodiment. As shown, the layer 424 is compressed so that the top surface 441 of the layer 424 is lowered to be substantially coplanar with the top surface 442 of the core 405. This compresses the layer 424 in order to fill the gaps 406. Additionally, the layer 424 may wrap around the edge or sidewall surface 443 of the base substrate 428. The compression of the layer 424 is possible because the layer 424 is only partially cured prior to being placed in the cavity 407. After the compression of the layer 424, the layer 424 may be fully cured. This secures the assembly 420 in place within the cavity 407.

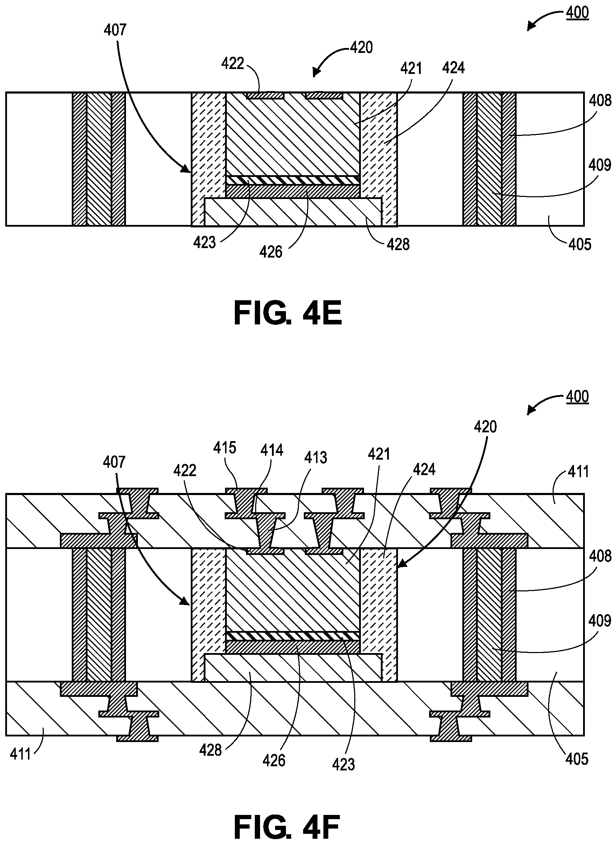

Referring now to Figure 4E, a cross-sectional illustration of the portion of the package substrate 400 after the tape 403 has been removed is shown, in accordance with an embodiment. The tape 403 may be removed with any suitable process. In some embodiments, the resulting structure includes portions of the layer 424 being exposed at both the top and bottom surface of the core 405.

Referring now to Figure 4F, a cross-sectional illustration of the portion of the package substrate 400 after buildup layers 411 are formed over and under the core 405 is shown, in accordance with an embodiment. In an embodiment, the buildup layers 411 may be organic buildup film that is deposited with lamination processes or the like. Electrical routing (e.g., vias 413, traces 414, pads 415, etc.) may be fabricated into and/or on the buildup layers 411 in order to provide electrical connections within the package substrate 400.

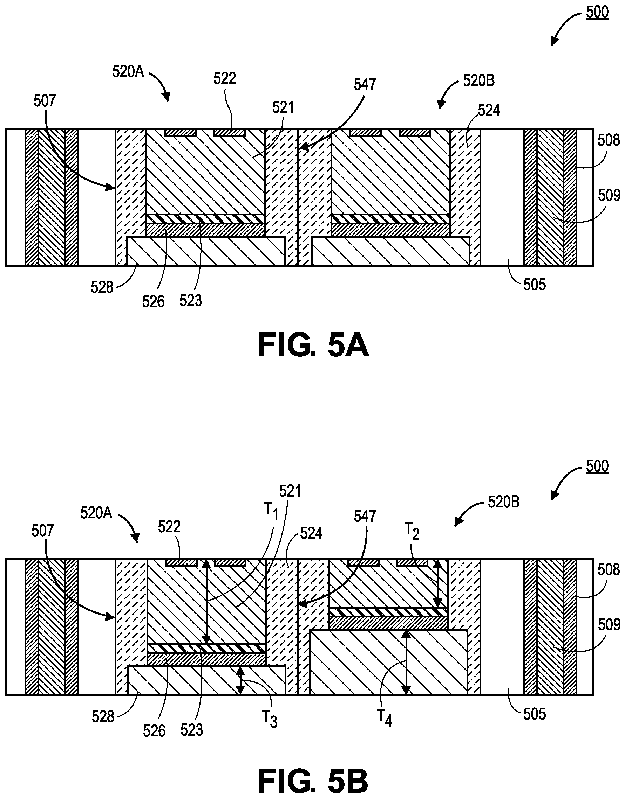

Referring now to Figure 5A, a cross-sectional illustration of a portion of a package substrate 500 is shown, in accordance with an additional embodiment. In an embodiment, the package substrate 500 may comprise a core 505, such as a glass core 505 or an organic core 505. The core 505 may be similar to other cores described in greater detail herein. In an embodiment, vias 508 (with or without insulating plugs 509) may pass through the core 505.

In an embodiment, a cavity 507 may be provided through a thickness of the core 505. A plurality of assemblies 520 may be embedded in the cavity 507. For example, a first assembly 520A and a second assembly 520B are shown in Figure 5A. The first assembly 520A and the second assembly 520B may be substantially similar to each other. For example, both may include a base substrate 528 that is coupled to a component substrate 521 by an adhesion promoting layer 526 and an adhesive layer 423. Additionally, pads 522 may be provided on each assembly 520. Layers 524 may surround both assemblies 520A and 520B. In some instances, a seam 547 may be visible between the assemblies 520A and 520B since separate layers 524 are compressed against each other. Though, in some instances the seam 547 may not be visibly discernable. In an embodiment, assemblies 520A and 520B may be similar to any assemblies described in greater detail herein.

Referring now to Figure 5B, a cross-sectional illustration of a portion of an electronic package 500 is shown, in accordance with an additional embodiment. The electronic package 500 in Figure 5B may be similar to the electronic package 500 in Figure 5A, with the exception of the structure of the first assembly 520A and the second assembly 520B. The component substrate 521 of the first assembly 520A may include a first thickness T₁ that is different than a second thickness T₂ of the component substrate 521 of the second assembly 520B. In order to maintain assemblies 520A and 520B with the same total thicknesses (that are substantially equal to the thickness of the core 505), the thicknesses of the base substrates 528 may be modified. For example, a third thickness T₃ of the base substrate 528 of the first assembly 520A may be different than a fourth thickness T₄ of the base substrate 528 of the second assembly 520B.

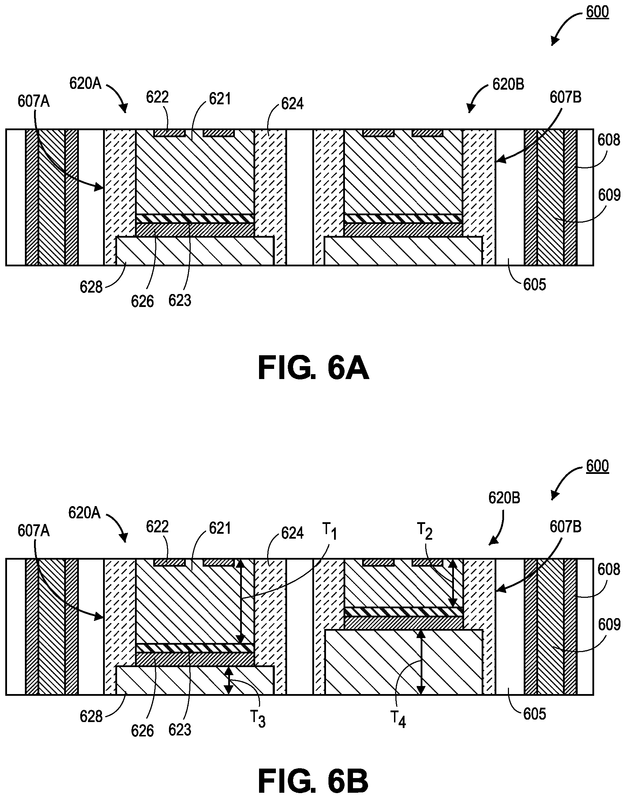

Referring now to Figure 6A, a cross-sectional illustration of a portion of a package substrate 600 is shown, in accordance with an additional embodiment. In an embodiment, the package substrate 600 may comprise a core 605, such as a glass core 605 or an organic core 605. The core 605 may be similar to other cores described in greater detail herein. In an embodiment, vias 608 (with or without insulating plugs 609) may pass through the core 605.

In an embodiment, a first cavity 607A and a second cavity 607B may be provided through a thickness of the core 605. An assembly 620A or 620B may be embedded in each of the cavities 607A and 607B. For example, a first assembly 620A may be provided in the first cavity 607A, and a second assembly 620B may be provided in the second cavity 607B. The first assembly 620A and the second assembly 620B may be substantially similar to each other. For example, both may include a base substrate 628 that is coupled to a component substrate 621 by an adhesion promoting layer 626 and an adhesive layer 623. Additionally, pads 622 may be provided on each assembly 620. Layers 624 may surround both assemblies 620A and 620B. In an embodiment, assemblies 620A and 620B may be similar to any assemblies described in greater detail herein.

Referring now to Figure 6B, a cross-sectional illustration of a portion of an electronic package 600 is shown, in accordance with an additional embodiment. The electronic package 600 in Figure 6B may be similar to the electronic package 600 in Figure 6A, with the exception of the structure of the first assembly 620A and the second assembly 620B. The component substrate 621 of the first assembly 620A may include a first thickness T₁ that is different than a second thickness T₂ of the component substrate 621 of the second assembly 620B. In order to maintain assemblies 620A and 620B with the same total thicknesses (that are substantially equal to the thickness of the core 605), the thicknesses of the base substrates 628 may be modified. For example, a third thickness T₃ of the base substrate 628 of the first assembly 620A and may be different than a fourth thickness T₄ of the base substrate 628 of the second assembly 620B.

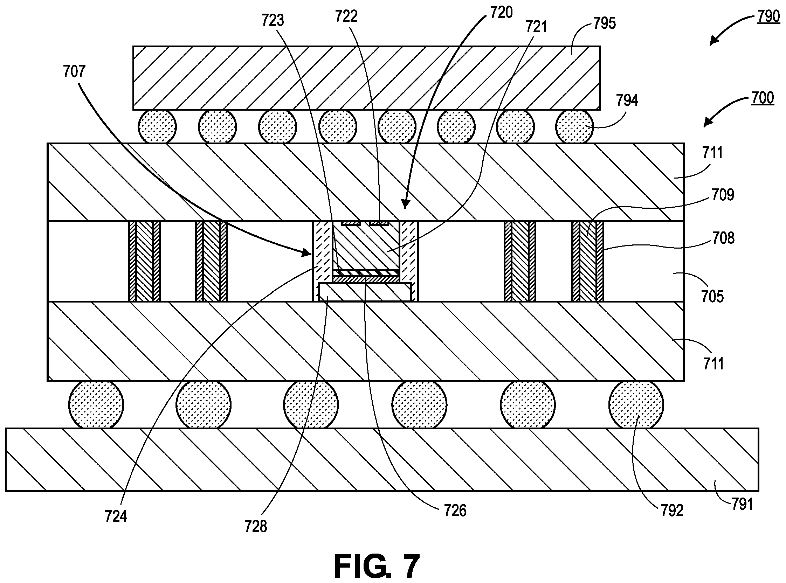

Referring now to Figure 7, a cross-sectional illustration of an electronic system 790 is shown, in accordance with an embodiment. In an embodiment, the electronic system 790 comprises a board, such as a printed circuit board (PCB), a motherboard, or the like. In an embodiment, the board 790 is coupled to a package substrate 700 by interconnects 792. The interconnects 792 may be second level interconnects (SLIs), such as solder balls, sockets, pins, or the like.

In an embodiment, the package substrate 700 may be similar to any of the package substrates described herein. For example, the package substrate 700 may include a core 705 (e.g., a glass core 705 or an organic core 705) with buildup layers 711 above and below the core 705. The core 705 may comprise vias 708. In Figure 7, the vias 708 are filled with an insulating plug 709. A cavity 707 may be provided through a thickness of the core 705. An assembly 720 may be set into the cavity 707.

In an embodiment, the assembly 720 may be similar to any of the devices described in greater detail herein. For example, the assembly 720 may comprise a passive component such as one or more of an inductor, a capacitor, a resistor, or the like. The assembly 720 may have a total thickness that is substantially equal to a thickness of the core 705. In an embodiment, the assembly 720 may comprise a base substrate 728 that is coupled to a component substrate 721 by an adhesion promoting layer 726 and an adhesion layer 723. A layer 724 may be provided around the base substrate 728 and the component substrate 721.

In an embodiment, one or more dies 795 may be coupled to the package substrate 700 by interconnects 794. The interconnects 794 may comprise first level interconnects (FLIs), such as solder balls, copper bumps, hybrid bonding interfaces, or the like. The die 795 may be any type of die, such as a central processing unit (CPU), a graphics processing unit (GPU), an XPU, a communications die, a memory die, an application specific integrated circuit (ASIC), a field programmable gate array (FPGA), or the like. In an embodiment, the assembly 720 is electrically coupled to the one or more dies 795 in order to control and/or improve power delivery that is provided to the die 795.

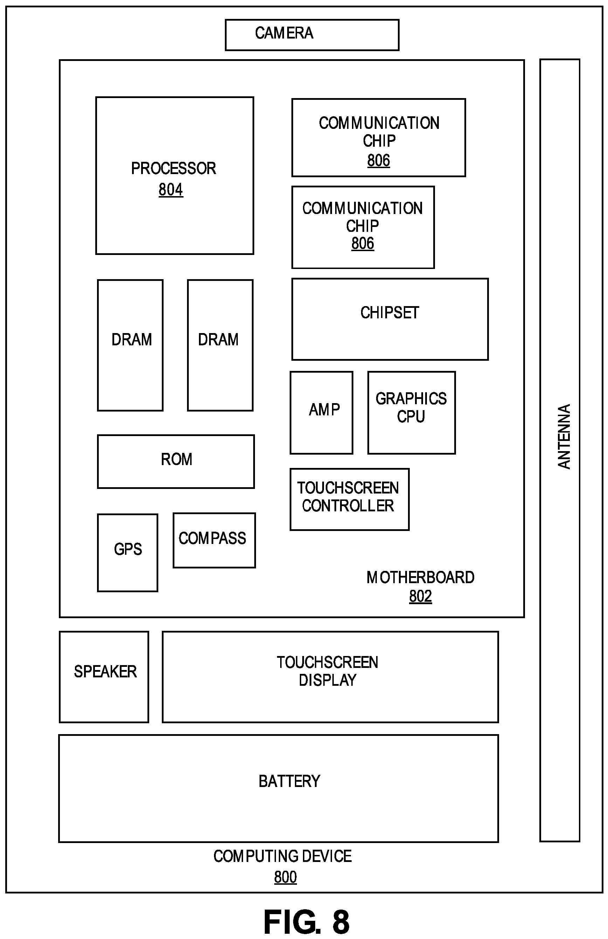

Figure 8 illustrates a computing device 800 in accordance with one implementation of the disclosure. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the disclosure, the integrated circuit die of the processor may be part of an electronic package that includes an assembly with a base substrate and a component substrate embedded in a layer and positioned in a core of the package substrate, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the disclosure, the integrated circuit die of the communication chip may be part of an electronic package that includes an assembly with a base substrate and a component substrate embedded in a layer and positioned in a core of the package substrate, in accordance with embodiments described herein.

In an embodiment, the computing device 800 may be part of any apparatus. For example, the computing device may be part of a personal computer, a server, a mobile device, a tablet, an automobile, or the like. That is, the computing device 800 is not limited to being used for any particular type of system, and the computing device 800 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: an apparatus, comprising: a first substrate with a first width; a first layer on the first substrate; a second substrate with a second width over the first layer, wherein the second width is smaller than the first width; and a second layer over the first substrate and around the second substrate.

Example 2: the apparatus of Example 1, wherein the first substrate comprises an organic dielectric with fiber reinforcement.

Example 3: the apparatus of Example 1 or Example 2, wherein the first substrate comprises a resin.

Example 4: the apparatus of Examples 1-3, further comprising: a third layer between the first substrate and the first layer, wherein the third layer comprises copper.

Example 5: the apparatus of Examples 1-4, wherein the first layer comprises an adhesive material.

Example 6: the apparatus of Examples 1-5, wherein a surface of the second layer is substantially coplanar with a surface of the second substrate.

Example 7: the apparatus of Examples 1-6, wherein the second substrate comprises one or more of an inductor, a capacitor, or an inductor.

Example 8: the apparatus of Examples 1-7, wherein the second layer covers a sidewall of the first substrate.

Example 9: the apparatus of Examples 1-8, wherein the component comprises silicon.

Example 10: the apparatus of Examples 1-9, wherein the second layer comprises a resin material or an epoxy material.

Example 11: an apparatus, comprising: a first substrate with a first thickness; a cavity through the first substrate; and an assembly in the cavity, wherein the assembly has a second thickness that is substantially equal to the first thickness, and wherein the assembly comprises: a second substrate; a component over the second substrate; and a layer over the second substrate and around the component, wherein a sidewall of the cavity is separated from a sidewall of the component by the layer.

Example 12: the apparatus of Example 11, wherein the component comprises one or more of an inductor, a capacitor, or a resistor.

Example 13: the apparatus of Example 11 or Example 12, wherein the assembly further comprises: an adhesive layer between the second substrate and the component.

Example 14: the apparatus of Example 13, wherein the assembly further comprises: a metallic layer between the adhesive layer and the second substrate.

Example 15: the apparatus of Examples 11-14, wherein the second substrate has a first width, and wherein the component has a second width that is smaller than the first width.

Example 16: the apparatus of Examples 11-15, wherein the first substrate is an organic core or a glass core with a rectangular prism form factor.

Example 17: an apparatus, comprising: a board; a package substrate coupled to the board, wherein the package substrate comprises: a core with a cavity; and an assembly in the cavity, wherein the assembly comprises: a substrate; a passive component over the substrate; and a mold layer surrounding the substrate and the passive component, wherein the mold layer contacts a sidewall of the cavity; and a die coupled to the package substrate.

Example 18: the apparatus of Example 17, wherein the mold layer separates a sidewall of the substrate from the sidewall of the cavity.

Example 19: the apparatus of Example 17 or Example 18, wherein the assembly further comprises: a metallic layer on the substrate; and an adhesive layer between the metallic layer and the passive component.

Example 20: the apparatus of Examples 17-19, wherein the apparatus is part of a personal computer, a server, a mobile device, a tablet, or an automobile.

## Claims

1. An apparatus, comprising:
a first substrate with a first width;
a first layer on the first substrate;
a second substrate with a second width over the first layer, wherein the second width is smaller than the first width; and
a second layer over the first substrate and around the second substrate.

2. The apparatus of claim 1, wherein the first substrate comprises an organic dielectric with fiber reinforcement.

3. The apparatus of claim 1 or 2, wherein the first substrate comprises a resin.

4. The apparatus of claim 1, 2 or 3, further comprising:
a third layer between the first substrate and the first layer, wherein the third layer comprises copper.

5. The apparatus of claim 1, 2, 3 or 4, wherein the first layer comprises an adhesive material.

6. The apparatus of claim 1, 2, 3, 4 or 5, wherein a surface of the second layer is substantially coplanar with a surface of the second substrate.

7. The apparatus of claim 1, 2, 3, 4, 5 or 6, wherein the second substrate comprises one or more of an inductor, a capacitor, or an inductor.

8. The apparatus of claim 1, 2, 3, 4, 5, 6 or 7, wherein the second layer covers a sidewall of the first substrate.

9. The apparatus of claim 1, 2, 3, 4, 5, 6, 7 or 8, wherein the component comprises silicon.

10. The apparatus of claim 1, 2, 3, 4, 5, 6, 7, 8 or 9, wherein the second layer comprises a resin material or an epoxy material.

11. A method of fabricating an apparatus, the method comprising:
forming a first substrate with a first width;
forming a first layer on the first substrate;
forming a second substrate with a second width over the first layer, wherein the second width is smaller than the first width; and
forming a second layer over the first substrate and around the second substrate.

12. The method of claim 11, wherein the first substrate comprises an organic dielectric with fiber reinforcement.

13. The method of claim 11 or 12, wherein the first substrate comprises a resin.

14. The method of claim 11, 12 or 13, further comprising:
forming a third layer between the first substrate and the first layer, wherein the third layer comprises copper.

15. The method of claim 11, 12, 13 or 14, wherein the first layer comprises an adhesive material.
